# EUROPEAN PATENT APPLICATION

(11) **EP 4 685 800 A1**
(43) Date of publication of application: **28.01.2026**
(21) Application number: 25188247.8
(22) Date of filing: 08.07.2025
(51) Int. Cl.: G11C 13/00, G11C 16/20, G11C 29/02, G11C 29/44, G11C 7/20, G11C 29/42, G11C 29/04

(54) **METHOD OF SELECTING TRIMMINGS IN NON-VOLATILE MEMORIES, CORRESPONDING DEVICE AND COMPUTER PROGRAM PRODUCT**

(30) Priority: 26.07.2024 IT 202400017500
(71) Applicant: STMicroelectronics International N.V., 1228 Plan-les-Ouates, Geneva (CH)
(72) Inventor: TOMAIUOLO, Francesco, I-95024 Acireale (Catania) (IT); DE COSTANTINI, Diego, I-96011 Augusta (Siracusa) (IT); RUTA, Marco, I-95027 San Gregorio di Catania (Catania) (IT); BUONO, Luigi, I-95030 Gravina di Catania (Catania) (IT); GIBILARO, Marco Eugenio, I-95021 Aci Castello (Catania) (IT); CONTE, Antonino, I-95030 Tremestieri Etneo (Catania) (IT)
(74) Representative: Buzzi, Notaro & Antonielli d'Oulx S.p.A.

(57) **Abstract**

A method (10ₐ), comprising:
selecting trimmings out of a set of candidate trimmings for analog blocks in a non-volatile memory, NVM, device and applying (104, 106) the selected trimmings to analog blocks in the non-volatile memory, NVM, device;
performing (108) a reading operation of a fixed pattern using analog blocks in the non-volatile memory device having applied thereto (104; 106) the selected trimmings, obtaining a read pattern;
checking (110) if the read pattern is equal to the fixed pattern;
in response to the read pattern being equal to the fixed pattern, selecting (Y₁) such selected trimmings as trimmings for application to the analog blocks;
in response to the read pattern being not equal to the fixed pattern and in the presence of trimmings still to be selected (124; N₃) in the set of candidate trimmings, selecting (122) out of the set of candidate trimmings a new set of trimmings and repeating with the new set of trimmings such performing (108), checking (110), and selecting (Y₁; 122) in response to such checking (110); and
in response to the read pattern being not equal to the fixed pattern and in the absence of trimmings still to be selected (124; Y₃) in the set of candidate trimmings, indicating (126) a failure in selecting such trimmings for application to the analog blocks.

## Description

### Technical field

The description relates to data storage technologies.

One or more embodiments can be applied to computer storage technologies such as non-volatile memories NVM, for instance, PCM, that is, Phase Change Memory such as ePCM (that is, embedded Phase Change Memory) and/or ePCM NVM (that is, Non-Volatile Memory ePCM).

### Background

Phase Change Memories, referred to as PCM, are a type of computer storage technology, that is, memory technology and, generally, a type of non-volatile random-access memory technology that can be embedded in integrated circuit (IC) semiconductor devices.

Usually, PCM operates on a bit-by-bit basis since the heat produced by an electric current flowing through a heating material called phase-change material such as, for instance, a chalcogenide glass, is used to melt and quench the phase-change material, making it amorphous, or to hold such phase-change material in its crystallization temperature range, thereby switching it to a crystalline state.

Therefore, a PCM storage unit may use such phase-change material to store 1-bit of information since the two states of the phase-change material, that is, amorphous or crystalline, are characterized by different resistance values that facilitate distinguishing one of the states from the other, that is, each of the two states corresponds to a different value of a single bit.

Thus, the phase-change material can stably exist in two states:
an amorphous or disordered state, characterized by high electrical resistivity, that is, by high resistance, for instance, about 0.6 MΩ, representing, for instance, a low logical state, for instance, '0', characterized by a low current flowing through it, or
a crystalline or ordered state, characterized by low electrical resistivity, that is, by low resistance, for example, a resistance lower than that of the amorphous state, for instance, about 18 kΩ, representing, for instance, a high logical state, for instance, '1', characterized by a high current flowing through it.

A PCM storage unit can switch between such two states by differently heating the phase-change material, that is, by applying a current to such phase-change material for a given time for switching to a first state and by applying a current of different value to such phase-change material for a different time for switching to a second state.

For instance, a "set" write operation of a specific cell, that is, setting the cell to a high logic level, may be performed by applying on the phase-change material of such specific cell a current that heats the respective phase-change material above a crystallization temperature associated to such respective phase-change material, but under a melt temperature associated with the same phase-change material, for a given time.

For instance, a "reset" write operation of a specific cell, that is, setting the cell to a low logic level, can be performed by applying on the phase-change material of such specific cell a current that heats the respective phase-change material above the melt temperature associated with such respective phase-change material for a given time, for instance, shorter than the one considered in a "set" write operation.

For instance, a read operation of a specific cell may be done by testing the resistance value, for instance, through a current pulse, of the phase-change material of the specific cell in order to detect the current phase, that is, amorphous or crystalline, of the phase-change material.

It is noted that "set" write operations and "reset" write operations may be collectively referred to as write operations in the following description, therefore, a write operation performed on a given cell may be either a set write operation, that is, to set such given cell to a high logic level, or a reset write operation, that is, to set such given cell to a low logic level.

A single-ended PCM is a type of PCM wherein a single cell corresponds to a single bit (that is, 1 cell/bit). Read operations in single-ended PCM are performed by using a reference current supplied, for instance, by a reference current generator, and a sense amplifier receiving:
at one terminal, a current from a PCM cell that is to be read, and
at the other terminal, a reference current supplied by the reference-current generator.

Document US 2009/0161417 A1 discloses two-cells-per-bit PCM architecture (that is, 2 cell/bit), that is, PCM architecture wherein two cells contain a single bit of data and one of the two cells, a complementary cell, is programmed to the complementary state of the other of the two cells. Thus, a bit is determined by reading a bit stored in one of the two cells and comparing it to the one stored in the complementary cell, thus, performing a differential reading operation.

A differential reading operation considers both the stored value of such data in a cell in its direct form, that is, high or low logic level respectively, and the stored value of such data in a complementary cell in its complemented form, that is, low or high logic level respectively, hence, the result of the differential reading operation is obtained through the use of a sense amplifier that is configured to receive at one terminal, for instance, on a first side, for instance, a left side, or on a second side, for instance, a right side, a current of the "direct" cell that has to be read, that is, containing the data in the direct form, and at the other terminal, for instance, on the second side or on the first side respectively, a current of the associated complementary cell, that is, containing the data in the complemented form.

Thus, the "direct" cell and the complementary cell are configured to be in opposite states. For instance, if one of the two cells, for instance, the direct cell, is in a SET state (characterized by low resistance and high current), the complementary cell is in a RESET state (characterized by high resistance and low current), or vice versa.

Therefore, the sense amplifier is configured to compare the current received from the direct cell and the current received from the associated complementary cell, and:
if the current received from the direct cell is higher than the current received from the associated complementary cell, the sense amplifier is configured to read a logic level equal to 1 ("one"), that is, a high logic level, and
if the current received from the direct cell is lower than the current received from the associated complementary cell, the sense amplifier is configured to read a logic level equal to 0 ("zero"), that is, a low logic level.

As a result, a reading operation of a bit in a two-cells-per-bit PCM may be more reliable than reading operations of bits in single-ended PCMs, as a read window in two-cells-per-bit PCMs is twice as wide as that used in single-ended PCMs.

The read window in two-cells-per-bit PCMs depends on a difference between a current flowing in a direct cell and a current flowing in an associated complementary cell, which corresponds to a difference between a current flowing within a cell set to a high logic level, that is, a current flowing in a direct or in a complementary cell, and a current flowing in a cell set to a low logic level, that is, a current flowing in a complementary or in a direct cell respectively.

Conversely, the read window in single-ended PCMs depends on a difference between a current flowing in a cell, that is, a current flowing within a cell set to a high or a low logic level, and a reference current, such reference current being midway between a current flowing within a cell set to a high logic level and a cell set to a low logic level.

Hence, two-cells-per-bit PCM architectures improve the reliability of read operations as a reference current is not needed since read operations are based on differential readings and as the two-cells-per-bit read window is doubled.

In addition, two-cells-per-bit PCM architectures may usually provide higher robustness, reliability, and retention at hot than single-ended PCM architectures as two-cells-per-bit PCMs are characterized by:
redundancy of information, that is, a single bit is stored in two cells instead of a single one, and
the possibility of implementing a differential reading strategy, that is, allowing the reading of the content of cells without using a reference current.

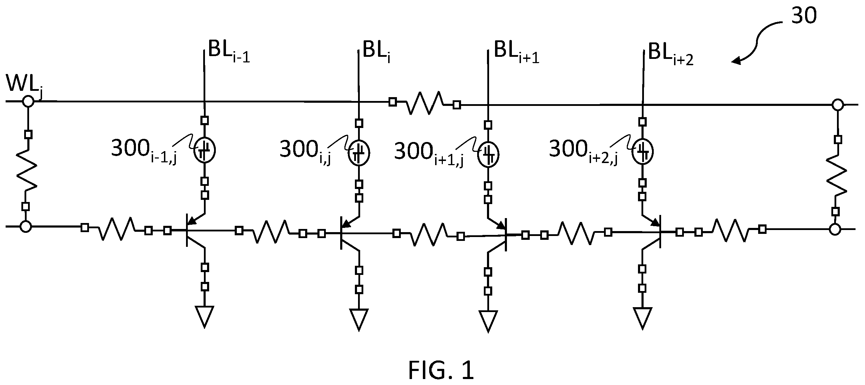

Figure 1 illustrates a conventional structure of a PCM array 30.

A PCM array 30, for instance, a two-cells-per-bit PCM array, may comprise one or more sets of cells, for instance, comprising cells 300_{i-1,j}, 300_{i,j}, 300_{i+1,j}, and 300_{i+2,j} of Figure 1, that are collectively referred to with the reference 300, coupled together.

It is noted that the resistances of Figure 1 are not physical elements but arise from parasitic connections.

It is noted that such one or more sets of cells 300 may be comprised in different subset of the array, for instance, either in a first subset of the PCM array 30, for instance, a subset of the PCM array comprising cells that are coupled to a first side of a sense amplifier, for instance, a left side, or in a second subset of such PCM array 30, for instance, a subset of the PCM array comprising cells that are coupled to a second side of such sense amplifier, for instance, a right side.

It is noted that, if a direct cell is comprised in the first subset of the PCM array 30, the respective complementary cell is comprised in the second subset of the PCM array 30, and vice versa.

The one or more sets of cells comprised in the PCM array are arranged in word lines WL, that are, the rows of the array, and bit lines BL, that are, the columns of the array.

Each cell in the plurality of cells 300 is coupled to a respective bit line BL and to a respective word line WL, for instance, through a bipolar transistor acting as selector.

Each cell in the plurality of cells 300 is coupled to a different pair of lines comprising a bit line BL and a word line WL, so that the respective bit line BL and the respective word line WL to which a given cell is coupled can be considered as providing coordinates to unambiguously identify such given cell.

For instance, the set of cells 300 illustrated in Figure 1 is comprised in a word line WLⱼ and each of such cells 300 is further coupled with a respective bit line, for instance, to a bit line BLᵢ₋₁, BLᵢ, BLᵢ₊₁, or BLᵢ₊₂ of Figure 1, that are collectively referred to with the reference BL.

It is noted that the cells 300 of the PCM array 30 may also be organized in tiles, such tiles being memory sub-blocks (that is, array sub-blocks) comprising cells that are arranged in bit lines BL and word lines WL, each of such tiles being accessible and operable independently.

In response to a Power On ("PO") Sequence, a phase-change memory and, more in general, a non-volatile memory ("NVM"), is usually configured to perform the following operations:
switching on the main analog blocks, for instance, voltage and current references, oscillators, pumps, regulators, and the like, in order to generate what is requested in the memory to perform the main operations, such as, for instance, read and write operations;
reading from a given zone of the NVM memory-related data such as, for instance, redundancy and configurations to be applied to the memory, such configurations comprising trimmings to be applied to the analog blocks of the NVM to compensate for process variations; and
writing such memory-related data in given volatile registers in order to render them effective.

Since the configurations comprise the trimmings of the NVM, such trimmings cannot be applied to the NVM during the PO sequence used to read such configurations.

In addition, part of such trimmings impacts on the reading operations since they are related to voltage and current references, voltages to be applied to the bit lines BL and word lines WL of the NVM, timing to be used during the read operations, and the like.

Therefore, the reading of the memory-related data, that is, the redundancy and configurations comprising the trimmings, is performed with untrimmed analog blocks.

Known solutions perform such reading of the memory-related data using a hardcoded trimming that considers PVT ("Process, Voltage and Temperature") variations.

For instance, to prevent that the reading operation of the memory-related data generates wrong data and, as a consequence, wrong redundancy and configurations, it is possible to:
read a fixed pattern, for instance, a hexadecimal pattern equal to 5555/AAAA, before reading the memory-related data in order to check the functionality of the circuitry involved in the read operation;
apply redundancy to the bits of such memory-related data, for instance, by applying a vote mechanism on each of the bits wherein each of such bits is written using more cells, that is, taking as value of a bit the value of the majority of cells storing a same bit, for instance, if each bit is stored in three cells, in case of an error on one of the bits, it is still possible to correct it by taking as value the value stored in the majority of cells; and/or
apply a CRC ("Cyclic Redundancy Check") technique in order to check the correctness of the memory-related data read.

In this way, it is possible to reduce the probability of having an error and of detecting the error itself, if present.

Therefore, if the CRC technique is applied, it is possible to check the correctness of the memory-related data and, if such memory-related data is correct, it is possible to use such information, for instance, by applying the read configurations to the memory.

A limitation of the known solution is that if an error is detected there is no way to recover from such error.

In that case, the memory is aware that an error is present but can only try to repeat the PO sequence in the expectation of recovering from such error.

It is noted that, even if most of the previous background is referred to phase change memories, such problems may also be present in typical non-volatile memories, NVM.

Solutions allowing recovers from errors detected during a power on sequence of a non-volatile memory may be advantageous in order to facilitate configuring the memory after such power on sequence, such errors being errors affecting memory-related data used for configuring such memory.

### Object and summary

An object of one or more embodiments is to contribute in providing recovering from errors detected during a power on sequence of a non-volatile memory in order to facilitate configuring such memory after the power on sequence, such errors affecting memory-related data used for configuring such memory.

According to one or more embodiments, that object is achieved via a method of selecting trimmings in non-volatile memories having the features set forth in the claims that follow.

One or more embodiments concern a corresponding device, that is, a corresponding non-volatile memory.

One or more embodiments concern a corresponding computer program product loadable in at least one control unit of a non-volatile memory and comprising software code portions for executing the steps of the method when the product is run.

As used herein, reference to such a computer program product is understood as being equivalent to reference to a computer-readable medium containing instructions for controlling a processing system in order to co-ordinate implementation of the method according to one or more embodiments.

The claims are an integral part of the technical teaching provided in respect of the embodiments.

Solutions as described herein refer to a method comprising:
selecting trimmings out of a set of candidate trimmings for analog blocks in a non-volatile memory, NVM, device and applying the selected trimmings to analog blocks in the non-volatile memory, NVM, device;
performing a reading operation of a fixed pattern using analog blocks in the non-volatile memory device having applied thereto said selected trimmings, obtaining a read pattern;
checking if said read pattern is equal to the fixed pattern;
in response to said read pattern being equal to the fixed pattern, selecting said selected trimmings as trimmings for application to the analog blocks;
in response to said read pattern being not equal to the fixed pattern and in the presence of trimmings still to be selected in the set of candidate trimmings, selecting out of the set of candidate trimmings a new set of trimmings and repeating with said new set of trimmings said performing, checking, and selecting in response to said checking; and
in response to said read pattern being not equal to the fixed pattern and in the absence of trimmings still to be selected in the set of candidate trimmings, indicating a failure in selecting said trimmings for application to the analog blocks.

Solutions as described herein facilitate achieving a recovery from errors detected during a power on sequence of a non-volatile memory in order to facilitate configuring such memory after the power on sequence, such errors being errors that affect memory-related data used for configuring such memory.

It is once more noted that, even if most of this description refers to phase change memories by way of example, issues addressed in solutions as described herein are not limited to such memories: consequently, solutions as described herein apply, in general, to non-volatile memories, NVMs where such issues may arise.

### Brief description of the figures

One or more embodiments will now be described, by way of example only, with reference to the annexed figures, wherein:
Figure 1 is a conventional structure of a PCM array;
Figures 2, 4, and 6 illustrate methods for selecting trimmings in non-volatile memories, for instance, phase change memories, according to embodiments of the present description; and
Figures 3A-3B and 5A-5B illustrate offsets being applied to reading operations in a phase change memory according to embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular configurations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

As previously described, solutions as described herein aim at allowing a recovery from errors affecting memory-related data used for the configuration of a non-volatile memory, for instance, a phase change memory, and detected during a power on sequence of such non-volatile memory in order to facilitate its configuration.

Solutions as described herein are related to a method for selecting (best) trimmings during a Power On, PO, sequence in order to apply such trimmings to the analog blocks of a non-volatile memory, NVM, for instance, a phase change memory.

In such a way, it is possible to compensate for analog blocks process variations and to increase the probability of reading correctly the memory-related data comprising, for instance, redundancy and configurations to be applied to the memory itself in order to complete the PO sequence correctly.

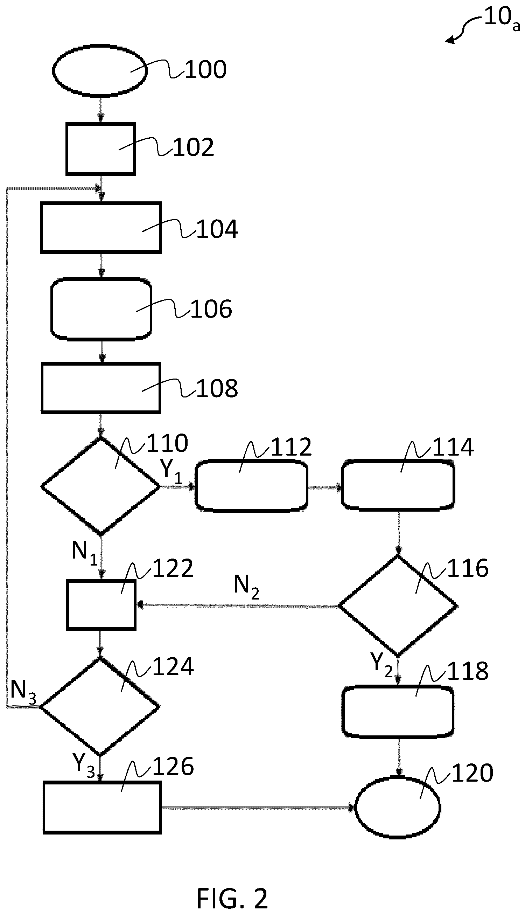

Figure 2 illustrates a first method 10ₐ for selecting trimmings in phase change memories (or, generally, non-volatile memories) according to embodiments of the present description.

It is noted that such first method 10ₐ may be applied both to single-ended PCMs and to two-cells-per-bit PCMs.

It is noted that even if the following description of the first method 10ₐ is focused on phase change memories, such first method 10ₐ can also be considered for non-volatile memories.

Such first method 10ₐ is based on:
reading a fixed pattern, for instance, the hexadecimal value 5555/AAAA, that includes both set, that is, high current, and reset, that is, low current, cells, and
changing, in response to a failure in reading the memory-related data comprising configurations to be applied to the memory, the trimmings.

Such trimmings are chosen from a set of possible trimmings that is defined considering the process variabilities.

The trimmings may be changed, choosing different trimmings from the set of possible trimmings, even in case of failure of a CRC ("Cyclic Redundancy Check") applied to the memory-related data read during the PO sequence in order to check their correctness.

It is noted that each time the trimmings are changed, the first method 10ₐ may wait for a given time interval in order to stabilize the outputs of the analog blocks.

The first method 10ₐ starts in a step 100 and then proceed to a first setting step 102, wherein such first method 10ₐ may be configured to set the value of a trimming variable N, that is, a variable indicative of trimmings to be used out of the set of possible trimmings, equal to zero, that is, N=0, therefore, indicating to use first trimmings out of such set of possible trimmings.

In a use trimmings step 104, the trimmings indicated by the trimming variable N as the trimmings to be used out of the set of possible trimmings can be applied to the analog blocks in order to compensate for process variations.

In a waiting step 106, the first method 10ₐ may wait for the given time interval in order to stabilize the outputs of the analog blocks after that the trimmings are applied thereon in the use trimming step 104.

In a first reading step 108, the fixed pattern, for instance, the hexadecimal value 5555/AAAA, is read and the value of the read pattern is checked in order to verify whether such read pattern is equal to such expected fixed pattern, in particular, such checking of the equality between such read pattern and the fixed pattern may be performed in a first checking step 110.

If the read pattern is equal to the fixed pattern, the first method 10ₐ proceed, following the branch indicated with the reference Y₁, to a second reading step 112 wherein the memory-related data comprising configurations to be applied to the memory are read.

In a CRC step 114, a CRC is calculated in order to perform such check over the read memory-related data in order to verify their correctness, in particular, the checking of the correctness may be performed in a second checking step 116 wherein the CRC calculated in the CRC step 114 is compared with an expected one and the read memory-related data are considered correct if such computed CRC is equal to the expected CRC.

If the CRC result indicates that the read memory-related data are correct, the first method 10ₐ proceed, following the branch indicated with the reference Y₂, to an apply configuration step 118 wherein configurations comprised in the read memory-related data are applied to the analog blocks in order to compensate for process variations during further reading operations and, more in general, during main operation performed by the memory after the PO sequence.

After the apply configuration step 118, the first method 10ₐ ends in a step 120.

Otherwise, if either the read pattern is different from the fixed pattern or the CRC result indicates that the read memory-related data are not correct, the first method 10ₐ proceed, following the branch indicated with the reference N₁ or N₂ respectively, to a second setting step 122.

In the second setting step 122, the first method 10ₐ may be configured to set the value of the trimming variable N to a different value, for instance, by increasing such trimming variable N of a value equal to one, that is, N=N+1, therefore, indicating to use trimmings different from the previously used trimmings out of such set of possible trimmings.

In a third checking step 124, the first method 10ₐ may be configured to check whether all the trimmings in the set of possible trimmings have been considered during the execution of the first method 10ₐ, for instance, by checking if the trimming variable N has reached a maximum value, that is, by checking if N=N_{MAX}, where N_{MAX} indicates the number of trimmings comprised in the set of possible trimmings.

If some of the trimmings in the set of possible trimmings have not been considered yet, that is, if N<N_{MAX}, the first method 10ₐ proceed, following the branch indicated with the reference N₃, to the use trimmings step 104 that applies one of the trimmings still non considered, that is, the trimmings selected in the second setting step 122, to the analog blocks.

Otherwise, if all of the trimmings in the set of possible trimmings have been considered, that is, if N=N_{MAX}, the first method 10ₐ proceed, following the branch indicated with the reference Y₃, to a failure step 126 indicative of a failure in configuring the memory via the memory-related data that comprises the configuration to be applied to the memory itself during a PO sequence.

After the failure step 126, the first method 10ₐ ends in the step 120.

Therefore, solutions as described herein refer to a method, for instance, the first method 10ₐ, comprising:
selecting, for instance, in a first setting step 102, trimmings out of a set of candidate trimmings for analog blocks in a non-volatile memory, NVM, for instance, a phase change memory, PCM, device 30, for instance, by setting the value of the trimming variable N;
applying, for instance, in the use trimmings step 104 and by waiting for the given time interval in the waiting step 106, the selected trimmings to analog blocks in the non-volatile memory, NVM, device 30;
performing, for instance, in the first reading step 108, a reading operation of a fixed pattern, for instance, the hexadecimal value 5555/AAAA, using analog blocks in the non-volatile memory device 30 having applied thereto such selected trimmings, obtaining a read pattern;
checking, for instance, in the first checking step 110, if such read pattern is equal to the fixed pattern;
in response to such read pattern being equal to the fixed pattern, selecting, following the branch indicated as Y₁ in Figure 2, such selected trimmings as trimmings for application to the analog blocks, that is, as trimmings to be applied during a power-on sequence to the analog blocks of the memory device in order to read, for instance, in the second reading step 112, the memory-related data comprising configurations to be applied, for instance, in the apply configuration step 118 (after a successful check in the CRC step 114 if present), to the memory during the operation of the non-volatile memory and for performing further reading and writing operations;
in response to such read pattern being not equal to the fixed pattern and in the presence of trimmings still to be selected (for instance, wherein such presence is checked in the third checking step 124) in the set of candidate trimmings, for instance, following the branch indicated as N₃ in Figure 2, selecting, for instance, in the second setting step 122, out of the set of candidate trimmings a new set of trimmings, for instance, by increasing such trimming variable N, and repeating with such new set of trimmings such performing, for instance, in such first reading step 108, checking, for instance, in such first checking step 110, and selecting, for instance, following the branch indicated as Y₁ in Figure 2 or in the second setting step 122, in response to such checking; and
in response to such read pattern being not equal to the fixed pattern and in the absence of trimmings still to be selected (for instance, wherein said absence is checked in the third checking step 124) in the set of candidate trimmings, for instance, following the branch indicated as Y₃ in Figure 2, indicating, for instance, in the failure step 126, a failure in selecting such trimmings for application to the analog blocks.

The method, for instance, the first method 10ₐ, according to solutions as described herein may comprise:
in response to such read pattern being equal to the fixed pattern, reading, for instance, in the second reading step 112, configuration data indicative of a configuration of the non-volatile memory "NVM", for instance, a phase change memory, PCM, device 30, that is, the memory-related data comprising configurations to be applied to the memory itself, using analog blocks of the non-volatile memory device 30 having applied thereto such selected trimmings for application to the analog blocks, obtaining read configuration data including error-detection bits, for instance, redundancy bits that may allow the detection and/or correction of errors affecting such memory-related data;
verifying, for instance, via the CRC step 114 and the second checking step 116, the correctness of the read configuration data based on such error-detection bits;
in response to the read configuration data being verified to be correct, applying, for instance, in the apply configuration step 118, such read configuration data to the non-volatile memory device 30; and
in response to the read configuration data being verified to be incorrect, selecting, for instance, in the second setting step 122, out of the set of candidate trimmings a new set of trimmings and repeating with such new set of trimmings such performing 108, checking 110, and selecting Y₁ or 122 in response to such checking.

It is noted that such verifying, for instance, performed via the CRC step 114 and the second checking step 116, the correctness of the read configuration data may be performed via a cyclic redundancy check, CRC.

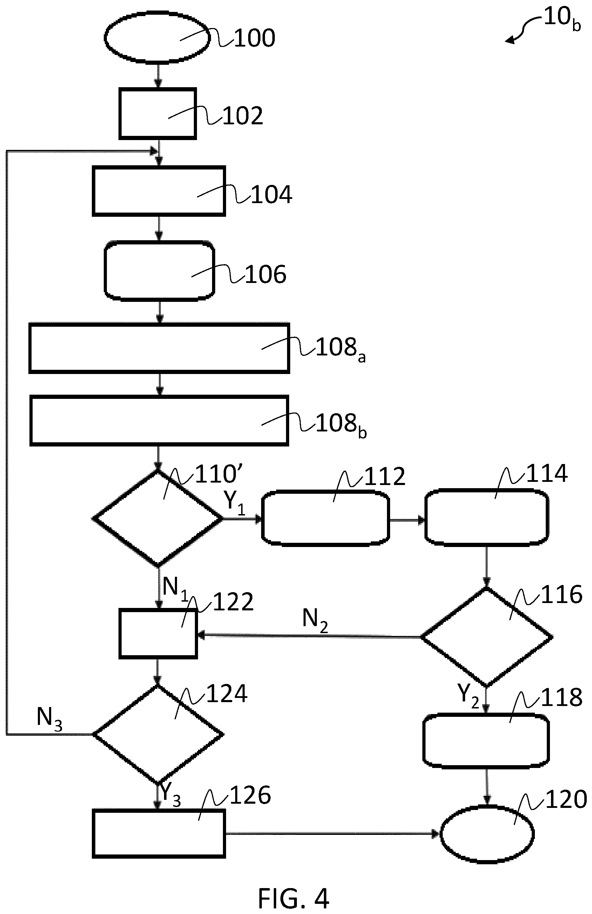

Figure 4 illustrates a second method 10_{b} for selecting trimmings in two-cells-per-bit phase change memories according to embodiments of the present description.

Such second method 10_{b} comprises some of the steps of the first method 10ₐ already described with reference to Figure 2, therefore, a description of such steps is not repeated in the following to enhance clarity and conciseness of the present description.

The first reading step 108 of the first method 10ₐ of Figure 2 is substituted, in embodiments according to Figure 4, with a first cell reading step 108ₐ and a second cell reading step 108_{b}.

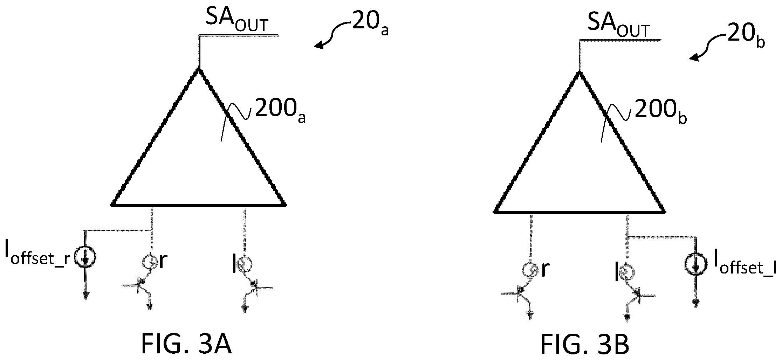

In the first cell reading step 108ₐ, the fixed pattern, for instance, the hexadecimal value 5555/AAAA, is read by adding a first offset current I_{offset_r} (referring to Figure 3A) to a first set of cells configured to store such fixed pattern.

For instance, such first set of cells comprises cells of the phase change memory that are coupled to right sides of respective sense amplifiers used for performing reading operations.

Therefore, the first offset current I_{offset_r} is applied to the sense amplifiers, for instance, to their respective right sides, used to read such first set of cells.

The first cell reading step 108ₐ is configured to obtain a value of the first read pattern, such value being checked in order to verify whether such first read pattern is equal to such expected fixed pattern.

Figure 3A illustrates a circuit 20ₐ that applies the first offset current I_{offset_r} to a cell of the first set of cells (it is noted that other cells in such first set of cells have a same circuit), for instance, a cell r of the phase change memory coupled to a right side of a sense amplifier 200ₐ used for performing reading operations via a sense amplifier output SA_{OUT}, in order to perform a reading operation of the fixed pattern according to embodiments of the present description.

In the second cell reading step 108_{b}, the fixed pattern, for instance, the hexadecimal value 5555/AAAA, is read by adding a second offset current I_{offset_l} (referring to Figure 3B), for instance, of value equal to the first offset current I_{offset_r}, to a second set of cells configured to store such fixed pattern.

For instance, such second set of cells comprises cells of the phase change memory that are coupled to left sides of respective sense amplifiers used for performing reading operations.

Therefore, the second offset current I_{offset_l} is applied to the sense amplifiers, for instance, to their respective left sides, used to read such second set of cells.

The second cell reading step 108_{b} is configured to obtain a value of the second read pattern, such value being checked in order to verify whether such second read pattern is equal to such expected fixed pattern.

Figure 3B illustrates a circuit 20_{b} that applies the second offset current I_{offset_l} to a cell of the second set of cells (it is noted that other cells in such second set of cells have a same circuit), for instance, a cell l of the phase change memory coupled to a left side of a sense amplifier 200_{b}, for instance, corresponding to the sense amplifier 200ₐ of Figure 3A, used for performing reading operations via a sense amplifier output SA_{OUT}, in order to perform a reading operation of the fixed pattern according to embodiments of the present description.

Therefore, the second method 10_{b} may comprise reading the fixed pattern two times, a first time by adding a first offset current I_{offset_r} to a first set of cells, for instance, cells coupled to right sides of respective sense amplifiers of the PCM, and a second time by adding a second offset current I_{offset_l} to a second set of cells, for instance, cells coupled to left sides of respective sense amplifiers of the PCM.

The equality between the first read pattern and the fixed pattern, and the second read pattern and the fixed pattern may be checked via a first checking step 110' that, differently from the first checking step 110 of Figure 2, is configured to proceed (following the branch indicated as Y₁) to the second reading step 112 if both the first read pattern and the second read pattern are equal to the fixed pattern, while if both or either one of the first read pattern and the second read pattern are/is different from the fixed pattern the second method 10_{b} proceed (following the branch indicated as N₁) to the second setting step 122.

Solutions according to Figure 4 allow to make the reading operations of the fixed pattern more critical if compared to solutions according to Figure 2 since reading operations of the fixed pattern in solutions according to Figure 4 are biased by offset currents.

Thus, trimmings to be used obtained with solutions according to Figure 4 may be more accurate than trimmings to be used obtained with solutions according to Figure 2 since the trimmings obtained with solutions according to Figure 4 are related to correct reading operations of the fixed pattern performed in more critical conditions than those of solutions according to Figure 2, therefore, reducing the probability of a failure during the reading of the memory-related data and of the configurations comprised therein, that is, reducing the failure probability during the CRC step 114 and the second checking step 116.

Therefore, in solutions according to the present description, the non-volatile memory, NVM, device 30 may be a two-cells-per-bit phase change memory, PCM, device.

In such a case, the phase change memory, PCM, device 30 may comprise a plurality of cells, for instance, the cells 300 illustrated in Figure 1, comprising:
direct cells, each configured to have written therein a direct bit value equal to one of a high logic level and a low logic level, and
complementary cells, each complementary cell being coupled to a respective direct cell and being configured to have written therein a complementary bit value equal to the other of such high logic level and low logic level.

It is noted that such phase change memory device 30 may comprise at least one sense amplifier, for instance, the sense amplifier 200ₐ and/or 200_{b} of Figures 3A and 3B, configured to have its input terminals coupled to a direct cell, for instance, the cell r coupled to the right side of such sense amplifier, and a respective complementary cell, for instance, the cell l coupled to the left side of such sense amplifier, such direct cell r being configured to store such fixed pattern.

Hence, the method, for instance, the second method 10_{b}, according to solutions as described herein, may comprise:
performing, for instance, in the second cell reading step 108_{b}, the reading operation of the fixed pattern, obtaining the read pattern, via such sense amplifier 200ₐ or 200_{b} having applied to its terminal coupled to the respective complementary cell l an offset current, for instance, the second offset current I_{offset_l};
performing, for instance, in the first cell reading step 108ₐ, a further reading operation of the fixed pattern using analog blocks of the phase change memory device 30 having applied thereto the selected trimmings, obtaining a further read pattern, such further reading operation being done via such sense amplifier 200ₐ or 200_{b} having applied to its terminal coupled to the direct cell r such offset current, for instance, the first offset current I_{offset_r}.

In such a case, the read pattern is considered equal to the fixed pattern in response to, for instance, following the branch indicated as Y₁ in Figure 4, such read pattern and such further read pattern being equal to such fixed pattern, and such read pattern is considered not equal to the fixed pattern in response to, for instance, following the branch indicated as N₁ in Figure 4, at least one of such read pattern and such further read pattern being not equal to such fixed pattern.

It is noted that solutions according to Figure 4 may also be applied to single-ended PCMs, that is, one-cell-per-bit PCMs, in order to obtain the advantages described above.

In such a case, the first reading step 108 of the first method 10ₐ of Figure 2 is substituted, in embodiments according to Figure 4 and related to single-ended PCMs, with a negative offset reading step 108ₐ and a positive offset reading step 108_{b}.

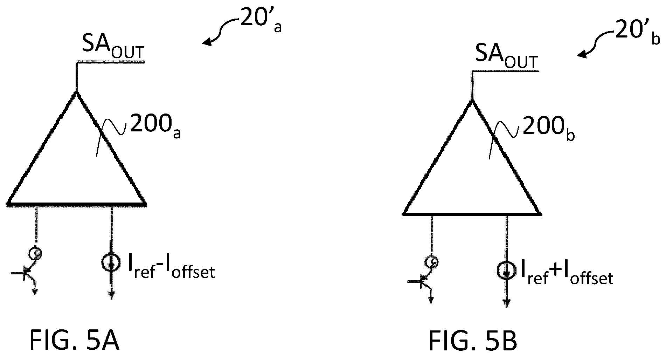

In the negative offset reading step 108ₐ, the fixed pattern, for instance, the hexadecimal value 5555/AAAA, is read adding a negative offset current I_{offset} (referring to Figure 5A) to a reference current I_{ref} used to read cells in a single-ended PCM, obtaining a first read pattern that is checked in order to verify whether such first read pattern is equal to such expected fixed pattern.

Figure 5A illustrates a circuit 20'ₐ that applies a negative offset current I_{offset} to a reference current I_{ref} used to read cells in a single-ended PCM in order to perform a reading operation of the fixed pattern according to embodiments of the present description, such cells being coupled to a sense amplifier 200ₐ used for performing reading operations via a sense amplifier output SA_{OUT}.

In the positive offset reading step 108_{b}, the fixed pattern, for instance, the hexadecimal value 5555/AAAA, is read adding a positive offset current I_{offset} (referring to Figure 5A), for instance, of absolute value equal to the negative offset current I_{offset}, to a reference current I_{ref} used to read cells in a single-ended PCM, obtaining a second read pattern that is checked in order to verify whether such second read pattern is equal to such expected fixed pattern.

Figure 5B illustrates a circuit 20'_{b} that applies a positive offset current I_{offset}, for instance, of absolute value equal to the negative offset current I_{offset}, to a reference current I_{ref} used to read cells in a single-ended PCM in order to perform a reading operation of the fixed pattern according to embodiments of the present description, such cells being coupled to a sense amplifier 200_{b}, for instance, corresponding to the sense amplifier 200ₐ of Figure 5A, used for performing reading operations via a sense amplifier output SA_{OUT}.

Therefore, the second method 10_{b} may comprise reading the fixed pattern two times, a first time by adding a negative offset current I_{offset} to a reference current I_{ref}, and a second time by adding a positive offset current I_{offset}, for instance, of absolute value equal to the negative offset current I_{offset}, to such reference current I_{ref}.

Also in this case, the equality between the first read pattern and the fixed pattern, and the second read pattern and the fixed pattern may be checked via a first checking step 110' that, differently from the first checking step 110 of Figure 2, is configured to proceed (following the branch indicated as Y₁) to the second reading step 112 if both the first read pattern and the second read pattern are equal to the fixed pattern, while if both or either one of the first read pattern and the second read pattern are/is different from the fixed pattern the second method 10_{b} proceed (following the branch indicated as N₁) to the second setting step 122.

Therefore, in solutions according to the present description, the non-volatile memory, NVM, device 30 may be a single-ended phase change memory, PCM, device, that is, a one-cell-per-bit PCM device.

In such a case, the phase change memory device 30 may comprise at least one sense amplifier, for instance, the sense amplifier 200ₐ and/or 200_{b} of Figures 5A and 5B, configured to have its input terminals coupled to a cell and to a reference current generator, for instance, a generator configured to generate the reference current I_{ref}, such cell being configured to store the fixed pattern.

Hence, the method, for instance, the second method 10_{b}, according to solutions as described herein, may comprise:
performing, for instance, in the positive offset reading step 108_{b}, the reading operation of the fixed pattern, obtaining the read pattern, via such sense amplifier 200ₐ or 200_{b} having applied to its terminal coupled to the reference current generator I_{ref} an offset current, for instance, the positive offset current I_{offset}, having a positive value;
performing, for instance, in the negative offset reading step 108ₐ, a further reading operation of the fixed pattern using analog blocks of the phase change memory device 30 having applied thereto the selected trimmings, obtaining a further read pattern, such further reading operation being done via such sense amplifier 200ₐ or 200_{b} having applied to its terminal coupled to the reference current generator I_{ref} an offset current, for instance, the negative offset current I_{offset}, having a negative value, such negative value having an absolute value equal to the positive value.

It is noted that also in this case, the read pattern is considered equal to the fixed pattern in response to, for instance, following the branch indicated as Y₁ in Figure 4, such read pattern and such further read pattern being equal to such fixed pattern, and such read pattern is considered not equal to the fixed pattern in response to, for instance, following the branch indicated as N₁ in Figure 4, at least one of such read pattern and such further read pattern being not equal to such fixed pattern.

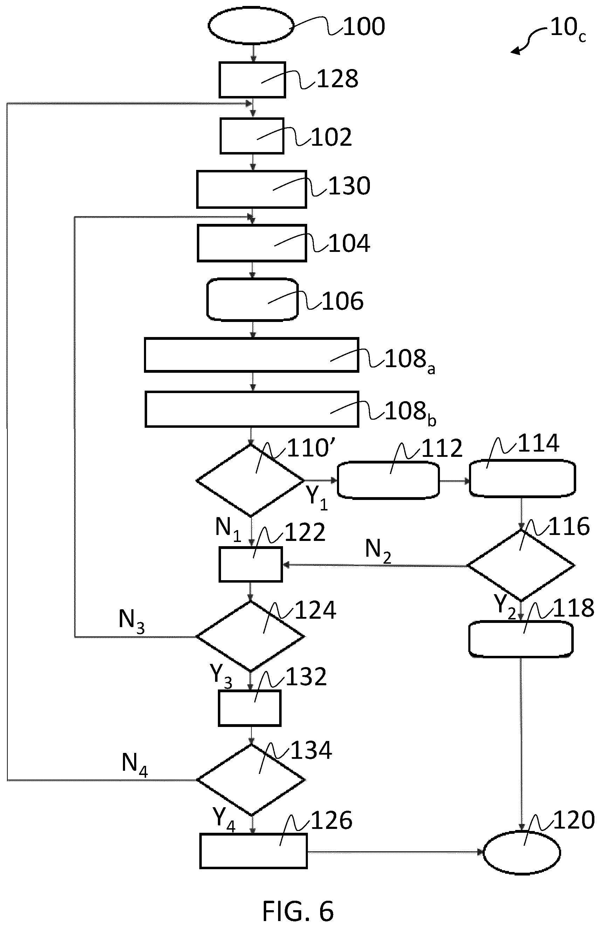

Figure 6 illustrates a third method 10_{c} for selecting trimmings in phase change memories according to embodiments of the present description.

Such third method 10_{c} comprises some of the steps of the first method 10ₐ and some of the steps of the second method 10_{b} already described with reference to Figures 2 and 4, therefore, a description of such steps is not repeated in the following in order to enhance clarity and conciseness of the present description.

Solutions according to Figure 6 provide the possibility of changing the value of the offset currents applied during reading operations of the fixed pattern, for instance, starting from a maximum value related to, for instance, a value M_{MAX}, and then decreasing such value in response to reading operations not performed correctly.

In such a way, it is possible to choose as trimmings to be used those trimmings that allow to read correctly the fixed pattern with the highest current that results in a correct read operation, therefore, allowing to select more accurate trimmings with respect to solutions according to Figures 2 and 4.

To this purpose, after the starting step 100, the third method 10_{c} may proceed to a first offset current setting step 128 wherein the values M related to the values of the offset currents, that is, to either the first offset current I_{offset_r} and the second offset current I_{offset_l} or the negative offset current I_{offset} and the positive offset current I_{offset}, are set to a maximum value M_{MAX}, that is, M=M_{MAX}.

After the first setting step 102, the third method 10_{c} may proceed to a generation step 130 wherein the offset currents to be applied (as previously described) during the reading operations of the fixed pattern are generated, for instance, by multiplying the values M related to the values of the offset currents by respective reference values, for instance, values of 1 µA ("microampere").

After the third checking step 124, if all of the trimmings in the set of possible trimmings have been considered, that is, if N=N_{MAX}, the third method 10_{c} may proceed, following the branch indicated with the reference Y₃, to a second offset current setting step 132 wherein the values M related to the values of the offset currents are decreased, for instance, of a value equal to one, that is, M=M-1.

In a fourth checking step 134, the third method 10_{c} may be configured to check whether the values M related to the values of the offset currents have fallen below a given lower threshold M_{MIN}, for instance, by checking if the values M are lower than the given lower threshold M_{MIN}, that is, by checking if M<M_{MIN}.

If the values M related to the values of the offset currents are higher than or equal to the given lower threshold M_{MIN}, the third method 10_{c} may proceed, following the branch indicated with the reference N₄, to the first setting step 102 that is configured to set again the trimming variable N to zero, that is, N=0, in order to indicate again to use the first trimmings out of such set of possible trimmings.

Otherwise, if the values M related to the values of the offset currents are lower than the given lower threshold M_{MIN}, the third method 10_{c} may proceed, following the branch indicated with the reference Y₄, to the failure step 126 indicative of a failure in configuring the memory via the memory-related data that comprises the configuration to be applied to the memory itself during a PO sequence.

It is noted that if the maximum value M_{MAX} is equal to the given lower threshold M_{MIN}, that is, M_{MAX}=M_{MIN}, the third method 10_{c} corresponds to the second method 10_{b}.

Similarly, if the maximum value M_{MAX} is equal to the given lower threshold M_{MIN}, such given lower threshold M_{MIN} being equal to zero, that is, M_{MAX}=M_{MIN}=0, the third method 10_{c} corresponds to the first method 10ₐ.

Therefore, the method, for instance, the third method 10_{c}, according to solutions as described herein, may comprise:
setting, for instance, in the first offset current setting step 128, the offset current, that is, either the second offset current I_{offset_l} and the first offset current I_{offset_r} or the positive and negative offset currents I_{offset}, to a maximum value, for instance, a value related to the variable M that is set to be equal to a maximum value M_{MAX}; and
prior performing such operation of indicating, for instance, in the failure step 126, a failure in selecting such trimmings for application to the analog blocks, and in response to such read pattern being not equal to the fixed pattern, to the absence of trimmings still to be selected, and to the offset current being higher than or equal to a minimum value, for instance, as verified in the fourth checking step 134, following the branch indicated as N₄ in Figure 6:
   decreasing, for instance, in the second offset current setting step 132, the value of such offset current, for instance, by decreasing such variable M;
   marking, for instance, in the first setting step 102, the trimmings comprised in the set of candidate trimmings as trimmings still to be selected, for instance, by setting the trimming variable N to a null value in order to indicate to select first trimmings out of the set of possible trimmings; and
   repeating such performing, for instance, in the first reading step 108, checking, for instance, in the first checking step 110', and selecting, for instance, either following the branch indicated as Y₁ in Figure 6 or in the second setting step 122, in response to such checking.

It is noted that the method according to solutions as described herein (either according to Figure 2, 4, or 6) may be performed in response to a power on, PO, sequence of the non-volatile memory, for instance, the phase change memory, device 30.

Solutions as described herein facilitate achieving a method comprising:
selecting trimmings out of a set of candidate trimmings for analog blocks in a non-volatile memory, NVM, device and applying the selected trimmings to analog blocks in the non-volatile memory, NVM, device;
performing a reading operation of a fixed pattern using analog blocks in the non-volatile memory device having applied thereto said selected trimmings, obtaining a read pattern;
checking if said read pattern is equal to the fixed pattern;
in response to said read pattern being equal to the fixed pattern, selecting said selected trimmings as trimmings for application to the analog blocks;
in response to said read pattern being not equal to the fixed pattern and in the presence of trimmings still to be selected in the set of candidate trimmings, selecting out of the set of candidate trimmings a new set of trimmings and repeating with said new set of trimmings said performing, checking, and selecting in response to said checking; and
in response to said read pattern being not equal to the fixed pattern and in the absence of trimmings still to be selected in the set of candidate trimmings, indicating a failure in selecting said trimmings for application to the analog blocks.

Solutions as described herein are also related to a non-volatile memory, NVM, device comprising analog blocks configured to have trimmings applied thereto, the NVM device being configured to implement the method according to solutions as described herein.

It is noted that, in embodiments, such non-volatile memory NVM device may be a phase change memory PCM device, for instance, a single-ended PCM device or a two-cells-per-bit PCM device.

Similarly, solutions as described herein are also related to a computer program product loadable in a control unit of a non-volatile memory, NVM, device, the NVM device comprising analog blocks configured to have trimmings applied thereto, the computer program product comprising portions of software code configured to cause the NVM device to implement the method according to solutions as described herein in response to the computer program product being run in the control unit of the NVM device.

Thus, solutions as described herein facilitate achieving a recovery from errors detected during a power on sequence of a non-volatile memory in order to facilitate configuring such memory after the power on sequence, such errors being errors that affect memory-related data used for configuring such memory.

In this way, it is also possible to increase the robustness of PO sequences of non-volatile memories.

Without prejudice to the underlying principles, the details and the embodiments may vary, even significantly, with respect to what has been described by way of example only without departing from the scope of the embodiments.

The extent of protection is determined by the annexed claims.

## Claims

1. A method (10ₐ, 10_{b}, 10_{c}), comprising:
selecting (102) trimmings out of a set of candidate trimmings for analog blocks in a non-volatile memory, NVM, device (30) and applying (104, 106) the selected trimmings to analog blocks in the non-volatile memory, NVM, device (30);
performing (108) a reading operation of a fixed pattern using analog blocks in the non-volatile memory device (30) having applied thereto (104; 106) said selected trimmings, obtaining a read pattern;
checking (110; 110') if said read pattern is equal to the fixed pattern;
in response to said read pattern being equal to the fixed pattern, selecting (Y₁) said selected trimmings as trimmings for application to the analog blocks;
in response to said read pattern being not equal to the fixed pattern and in the presence of trimmings still to be selected (124; N₃) in the set of candidate trimmings, selecting (122) out of the set of candidate trimmings a new set of trimmings and repeating with said new set of trimmings said performing (108), checking (110; 110'), and selecting (Y₁; 122) in response to said checking (110; 110'); and
in response to said read pattern being not equal to the fixed pattern and in the absence of trimmings still to be selected (124; Y₃) in the set of candidate trimmings, indicating (126) a failure in selecting said trimmings for application to the analog blocks.

2. The method (10ₐ, 10_{b}, 10_{c}) according to claim 1, comprising:
in response to said read pattern being equal to the fixed pattern, reading (112) configuration data indicative of a configuration of the non-volatile memory device (30) using analog blocks of the non-volatile memory device (30) having applied thereto said selected trimmings for application to the analog blocks, obtaining read configuration data including error-detection bits;
verifying (114; 116) the correctness of the read configuration data based on said error-detection bits;
in response to the read configuration data being verified to be correct, applying (118) said read configuration data to the non-volatile memory device (30); and
in response to the read configuration data being verified to be incorrect, selecting (122) out of the set of candidate trimmings a new set of trimmings and repeating with said new set of trimmings said performing (108), checking (110; 110'), and selecting (Y₁; 122) in response to said checking (110; 110').

3. The method (10ₐ, 10_{b}, 10_{c}) according to claim 2, wherein said verifying (114; 116) the correctness of the read configuration data is performed via a cyclic redundancy check, CRC.

4. The method (10ₐ, 10_{b}, 10_{c}) according to any of the previous claims, wherein said non-volatile memory, NVM, device (30) is a two-cells-per-bit phase change memory, PCM, device.

5. The method (10ₐ, 10_{b}, 10_{c}) according to claim 4, wherein the two-cells-per-bit phase change memory, PCM, device (30) comprises a plurality of cells (300) comprising:
direct cells, each configured to have written therein a direct bit value equal to one of a high logic level and a low logic level, and
complementary cells, each complementary cell being coupled to a respective direct cell and being configured to have written therein a complementary bit value equal to the other of said high logic level and low logic level.

6. The method (10_{b}, 10_{c}) according to claim 5, wherein the two-cells-per-bit phase change memory device (30) comprises at least one sense amplifier (200ₐ; 200_{b}) configured to have its input terminals coupled to a direct cell (r) and a respective complementary cell (l), said direct cell (r) storing said fixed pattern;
wherein:
the operation of performing (108_{b}) the reading operation of the fixed pattern, obtaining the read pattern, is done via said sense amplifier (200ₐ; 200_{b}) having applied to its terminal coupled to the respective complementary cell (l) an offset current (I_{offset_1});
said method (10_{b}, 10_{c}) comprises performing (108ₐ) a further reading operation of the fixed pattern using analog blocks of the two-cells-per-bit phase change memory device (30) having applied thereto (104; 106) said selected trimmings, obtaining a further read pattern, said further reading operation being done via said sense amplifier (200ₐ; 200_{b}) having applied to its terminal coupled to the direct cell (r) said offset current (I_{offset_r}); and
said read pattern is equal to the fixed pattern in response to (Y₁) said read pattern and said further read pattern being equal to said fixed pattern, and said read pattern is not equal to the fixed pattern in response to (N₁) at least one of said read pattern and said further read pattern being not equal to said fixed pattern.

7. The method (10ₐ, 10_{b}, 10_{c}) according to any of claims 1 to 3, wherein said non-volatile memory, NVM, device (30) is a single-ended phase change memory, PCM, device.

8. The method (10_{b}, 10_{c}) according to claim 7, wherein the single-ended phase change memory device (30) comprises at least one sense amplifier (200ₐ; 200_{b}) configured to have its input terminals coupled to a cell and to a reference current generator (I_{ref}), said cell storing said fixed pattern;
wherein:
the operation of performing (108_{b}) the reading operation of the fixed pattern, obtaining the read pattern, is done via said sense amplifier (200ₐ; 200_{b}) having applied to its terminal coupled to the reference current generator (I_{ref}) an offset current (I_{offset}) having a positive value;
said method (10_{b}, 10_{c}) comprises performing (108ₐ) a further reading operation of the fixed pattern using analog blocks of the single-ended phase change memory device (30) having applied thereto (104; 106) said selected trimmings, obtaining a further read pattern, said further reading operation being done via said sense amplifier (200ₐ; 200_{b}) having applied to its terminal coupled to the reference current generator (I_{ref}) an offset current (I_{offset}) having a negative value, said negative value having an absolute value equal to the positive value; and
said read pattern is equal to the fixed pattern in response to (Y₁) said read pattern and said further read pattern being equal to said fixed pattern, and said read pattern is not equal to the fixed pattern in response to (N₁) at least one of said read pattern and said further read pattern being not equal to said fixed pattern.

9. The method (10_{c}) according to claim 6 or claim 8, comprising:
setting (128) the offset current (I_{offset_l}; I_{offset_r}; I_{offset}) to a maximum value; and
prior performing said operation of indicating (126) a failure and in response to said read pattern being not equal to the fixed pattern, to the absence of trimmings still to be selected (124; Y₃), and to the offset current (I_{offset_l}; I_{offset_r}; I_{offset}) being higher than or equal to (134; N₄) a minimum value:
decreasing (132) the value of said offset current (I_{offset_l}; I_{offset_r}; I_{offset});
marking (102) the trimmings comprised in the set of candidate trimmings as trimmings still to be selected; and
repeating said performing (108), checking (110'), and selecting (Y₁; 122) in response to said checking (110').

10. The method (10ₐ, 10_{b}, 10_{c}) according to any of the previous claims, wherein said method (10ₐ, 10_{b}, 10_{c}) is performed in response to a power on, PO, sequence of the non-volatile memory device (30).

11. A non-volatile memory, NVM, device (30) comprising analog blocks configured to have trimmings applied thereto, the NVM device (30) being configured to implement the method (10ₐ, 10_{b}, 10_{c}) according to any of the previous claims.

12. A computer program product loadable in a control unit of a non-volatile memory, NVM, device (30), the NVM device (30) comprising analog blocks configured to have trimmings applied thereto, the computer program product comprising portions of software code configured to cause the NVM device (30) to implement the method (10ₐ, 10_{b}, 10_{c}) according to any of claims 1 to 10 in response to the computer program product being run in the control unit of the NVM device (30).
